# EUROPEAN PATENT APPLICATION

(11) **EP 4 734 322 A1**
(43) Date of publication of application: **29.04.2026**
(21) Application number: 24839947.9
(22) Date of filing: 26.06.2024
(51) Int. Cl.: H02J 7/00, G06F 13/38, G01R 15/14, G01R 19/00, G01R 19/165

(54) **CHARGING DEVICE FOR PROVIDING POWER ON BASIS OF USB PD, AND OPERATING METHOD THEREOF**

(30) Priority: 10.07.2023 KR 20230088806; 12.10.2023 KR 20230136242
(71) Applicant: Samsung Electronics Co., Ltd., Suwon-si, Gyeonggi-do 16677 (KR)
(72) Inventor: OH, Hyunjun, Suwon-si Gyeonggi-do 16677 (KR); KIM, Yeongil, Suwon-si Gyeonggi-do 16677 (KR); CHOI, Hangseok, Suwon-si Gyeonggi-do 16677 (KR); KANG, Sangwoo, Suwon-si Gyeonggi-do 16677 (KR); LEE, Kyunghwan, Suwon-si Gyeonggi-do 16677 (KR); CHOI, Kyusik, Suwon-si Gyeonggi-do 16677 (KR)
(74) Representative: HGF
(86) International application number: PCT/KR2024/008889
(87) International publication number: WO 2025/014133

(57) **Abstract**

A charging device for supporting universal serial bus (USB) power delivery (PD), according to one embodiment, may comprise a connector, a communication circuit, and a compensation circuit, which includes a detection circuit and a signal synthesizer. The compensation circuit according to one embodiment can be configured to: receive, through a configuration channel (CC) line of a cable connected to the connector, a communication signal related to charging of an electronic device (421) from the electronic device; acquire, through the detection circuit, a first signal indicating a bottom voltage of the communication signal; output, to the communication circuit, through the signal synthesizer, a second signal in which an offset voltage corresponding to a ground level of the communication signal is removed by subtracting the first signal from the communication signal; and allow a USB PD to communicate with the electronic device on the basis of the second signal.

## Description

### [Technical Field]

The disclosure relates to a charging device for supplying power based on Universal Serial Bus (USB) Power Delivery (PD) and a method of operating the same.

### [Background Art]

An electronic device may be connected to various external devices and may receive data from external devices or transmit data to external devices. In addition, the electronic device may receive power from external devices or transmit power to external devices. The electronic device includes an interface (e.g., a connector) for connection with external devices, and may be connected to various external devices through the interface to provide extended functions while being connected thereto. The electronic device may include various types of connectors according to various interfaces.

Through a connector used for charging or for input and output of data, an electronic device may be electrically connected to a charging device that charges the electronic device, and may also serve to supply power to an external device connected to the electronic device. For example, Universal Serial Bus (USB) Type-C serves as a connector for the electronic device and, through the USB Type-C connector, the electronic device may transmit power to or receive power from an external device, or perform data transmission and reception with the external device.

When an electronic device is physically connected to an external device through a connector as described above, a role of a host and/or a client may be determined. For example, it may be determined whether to operate as a source that supplies power or as a sink that receives power. In this case, the electronic device may identify whether it is physically connected to the external device based on a voltage level detected at an identification terminal (e.g., a configuration channel) of the connector, and may transmit or receive power while being physically connected.

### [Detailed Description of the Invention]

### [Technical Solution]

According to an embodiment, a charging device configured to support Universal Serial Bus (USB) Power Delivery (PD) may comprise a connector, a communication circuit, and a compensation circuit including a detection circuit and a signal synthesizer. According to an embodiment, the compensation circuit may be configured to receive, through a configuration channel (CC) line of a cable connected to the connector, a communication signal from an electronic device 421, the communication signal being related to charging of the electronic device. According to an embodiment, the compensation circuit may be configured to obtain, through the detection circuit, a first signal indicating a bottom voltage of the communication signal. According to an embodiment, the compensation circuit may be configured to output, to the communication circuit, a second signal obtained by subtracting the first signal from the communication signal through the signal synthesizer, the second signal thereby having an offset voltage corresponding to a ground level of the communication signal removed therefrom. According to an embodiment, the communication circuit may be configured to perform USB PD communication with the electronic device based on the second signal.

According to an embodiment, a method of operating a charging device configured to support Universal Serial Bus (USB) Power Delivery (PD) may comprise receiving, through a configuration channel (CC) line of a cable connected to a connector 505 of the charging device, a communication signal related to charging of an electronic device, from the electronic device 421. According to an embodiment, the method of operating the charging device may include obtaining, using a detection circuit included in the charging device, a first signal indicating a bottom voltage of the communication signal. According to an embodiment, the method of operating the charging device may include outputting, to a communication circuit included in the charging device, a second signal obtained by subtracting the first signal from the communication signal using a signal synthesizer included in the charging device, the second signal thereby having an offset voltage corresponding to a ground level of the communication signal removed therefrom. According to an embodiment, the method of operating the charging device may include performing USB PD communication with the electronic device based on the second signal through the communication circuit.

### [Brief Description of the Drawings]

FIG. 1 is a block diagram of an electronic device in a network environment according to an embodiment;
FIG. 2 is a perspective view of a charging device (or adapter) 200 including a connector according to an embodiment;
FIG. 3 is a diagram illustrating a connection between a charging device and an external electronic device according to an embodiment;
FIG. 4A is a diagram illustrating a voltage drop caused by a cable supporting USB Type-C and connecting a charging device and an electronic device, according to an embodiment;
FIG. 4B is a diagram illustrating a voltage drop on a ground line included in a cable supporting USB Type-C according to an embodiment;
FIG. 4C is a diagram illustrating a change in a ground level of a communication signal received by a charging device due to a voltage drop on a ground line included in a cable supporting USB Type-C according to a comparative embodiment;
FIG. 5 is a block diagram of a charging device that includes a compensation circuit configured to compensate a ground voltage of a communication signal received through a configuration channel (CC) line according to an embodiment;
FIG. 6 is a circuit diagram illustrating a detection circuit configured to detect a bottom voltage of a communication signal received through a configuration channel (CC) line according to an embodiment;
FIG. 7 is a circuit diagram illustrating a detection circuit configured to detect a bottom voltage of a communication signal received through a configuration channel (CC) line according to an embodiment;
FIG. 8 is a flowchart illustrating an operation of a charging device that includes a compensation circuit configured to compensate a ground voltage of a communication signal received through a configuration channel (CC) line according to an embodiment;
FIG. 9A is a graph illustrating a signal indicating a bottom voltage of a communication signal obtained through a detection circuit according to an embodiment; and
FIG. 9B is a graph illustrating a signal in which a ground voltage of a communication signal is compensated through a compensation circuit according to an embodiment.

### [Mode for Carrying out the Invention]

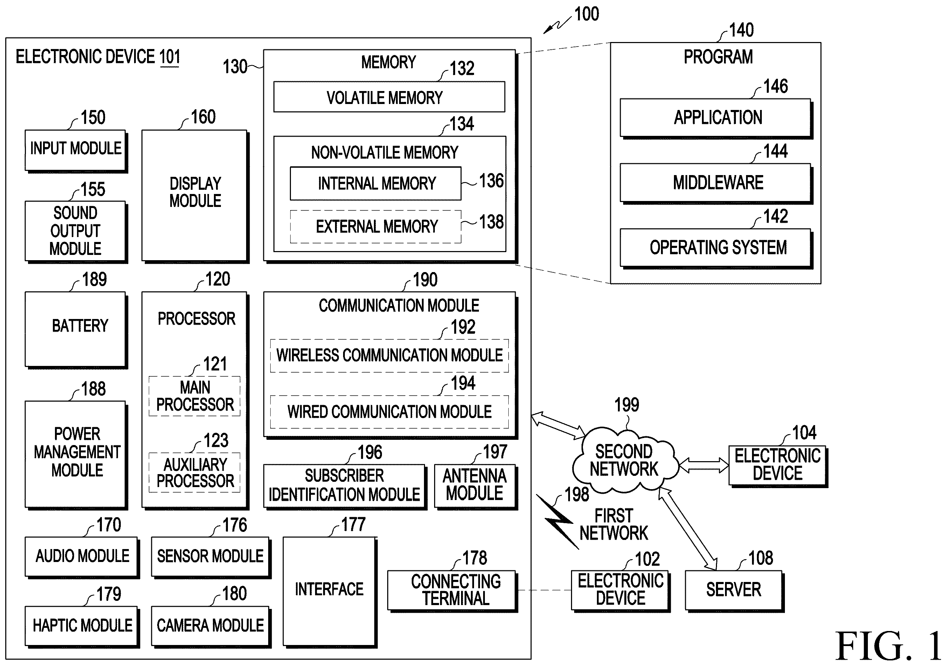

FIG. 1 is a block diagram illustrating an electronic device 101 in a network environment 100 according to an embodiment. Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). According to an embodiment, the electronic device 101 may communicate with the external electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least portion of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as portion of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as portion of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as portion of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or via an external electronic device (e.g., electronic device 102, such as a speaker or a headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the external electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least portion of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the external electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other portions (e.g., radio frequency integrated circuit (RFIC)) than the radiator may be further formed as portion of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least portion of the function or the service. The one or more external electronic devices receiving the request may perform the at least portion of the function or the service requested, or an additional function or an additional service related to the request, and transfer an outcome of the performing to the electronic device 101. The electronic device 101 may provide the outcome, with or without further processing of the outcome, as at least portion of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

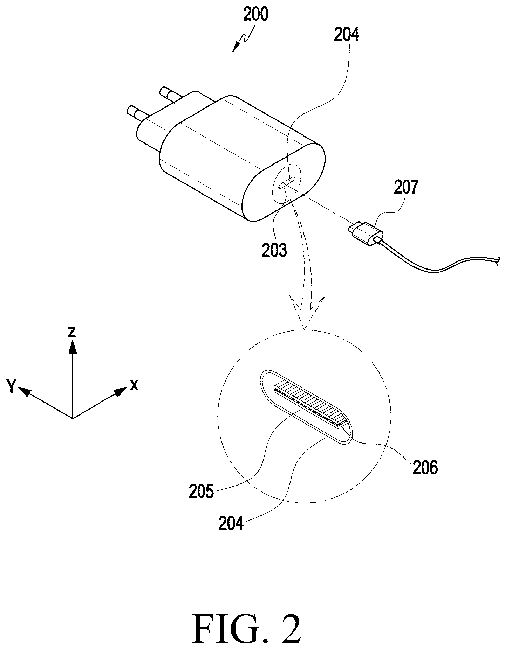

FIG. 2 is a perspective view of a charging device (or adapter) 200 including a connector according to an embodiment. Referring to FIG. 2, in a three-axis orthogonal coordinate system, 'X' may indicate a width direction of the charging device 200, 'Y' may indicate a length direction of the charging device 200, and 'Z' may indicate a thickness direction of the charging device 200.

According to an embodiment, the charging device 200 may be implemented as a charger, an adapter, a laptop, a travel adapter (TA), or an auxiliary battery. Depending on the implementation, the charging device 200 may include at least a portion of the components of the electronic device 101 of FIG. 1.

According to an embodiment, the charging device 200 may include a housing 201. According to an embodiment, the housing 201 may be formed of a non-conductive member. Depending on the implementation, a portion of the housing 201 may be formed of a conductive member.

According to an embodiment, the charging device 200 may include a connector 203 (e.g., the connecting terminal 178 of FIG. 1) configured to be connected directly or indirectly (e.g., indirectly through a cable) to an external electronic device. According to an embodiment, the connector 203 may be a socket-type connector.

According to an embodiment, an opening 204 may be formed in at least a portion of the housing 201 such that the connector 203 is exposed, and the connector 203 may be disposed within the opening 204. According to an embodiment, an external connector 207 in the form of a header may be coupled to the connector 203 in a normal or reverse direction. That is, the external connector 207 may be inserted into the connector 203 in either direction regardless of orientation. According to an embodiment, the external connector 207 may be connected to an external electronic device through a cable, and as the connector 203 and the external connector 207 are coupled, the charging device 200 and the external electronic device may be connected. According to an embodiment, external electronic devices may be various types of devices connectable to the charging device 200. For example, an external electronic device (e.g., the electronic device 101 of FIG. 1) may include a smartphone, an audio device, a laptop, and/or a computer.

According to an embodiment, the charging device 200 may include a connecting part for connecting to a power source (not shown). For example, the connecting part may be implemented in the form of a cord. For example, the charging device 200 may receive power from a wall outlet through the connecting part, convert the received power, and supply the converted power to an external electronic device.

According to an embodiment, the connector 203 may be used as an interface for connecting the charging device 200 and an external electronic device. The charging device 200 may transmit data of the charging device 200 to the external electronic device or receive data from the external electronic device through an external connector 207 connected to the connector 203. In addition, the charging device 200 may provide power to the external electronic device through the connector 203. According to an embodiment, the connector 203 may include a Universal Serial Bus (USB) Type-C and a contact substrate 205 may be formed inside the connector. In addition, a mid-plate 206 having electrical conductivity may be formed inside the contact substrate 205, and a plurality of pins may be formed on an upper surface and a lower surface of the contact substrate 205.

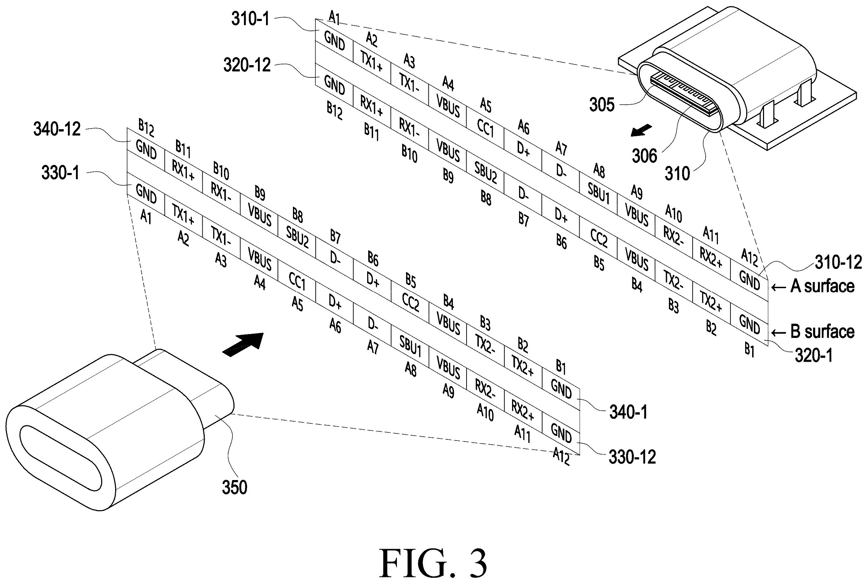

FIG. 3 is a diagram illustrating a connection between a charging device and an external electronic device according to an embodiment.

Referring to FIG. 3, a charging device (e.g., the charging device 200 of FIG. 2) may be electrically connected to an external electronic device through a first connector 310. For example, the first connector 310 may include a Universal Serial Bus (USB) Type-C.

According to an embodiment, an outer shape of the first connector 310 of the charging device may be configured to allow a second connector 350 of the external electronic device to be inserted in either a normal or reverse direction, and a contact substrate 305 may be formed inside the first connector 310.

According to an embodiment, the contact substrate 305 may have twelve pins (or terminals) 310-1, 310-2, ..., 310-12 formed on a first surface (e.g., an A surface) corresponding to the normal direction, and twelve pins (or terminals) 320-1, 320-2, ..., 320-12 formed on a second surface (e.g., a B surface) corresponding to the reverse direction. A mid-plate 306 having electrical conductivity may be disposed within the contact substrate 305.

According to an embodiment, a second connector 350 in the form of a cable connectable to an external electronic device may include twelve pins 330-1, 330-2, ..., 330-12 formed on a first surface (e.g., an A surface) to contact twelve pins 310-1, 310-2, ..., 310-12 formed on the first surface (e.g., the A surface) of the contact substrate 305, and twelve pins 340-1, 340-2, ..., 340-12 formed on a second surface (e.g., a B surface) to contact twelve pins 320-1, 320-2, ..., 320-12 formed on the second surface (e.g., the B surface) of the contact substrate 305. For example, the second connector 350 may include a Universal Serial Bus (USB) Type-C. The number of pins provided in the second connector 350 may vary depending on the type of the external electronic device. In addition, the number of configuration channel (CC) pins of the external electronic device may be one or two depending on the type of the device. For example, to allow the second connector 350 to be inserted in either direction with respect to the first surface or the second surface, an arrangement order of the twelve pins formed on the first surface (e.g., an A surface) may be the same as the arrangement order of the twelve pins formed on the second surface (e.g., a B surface). Due to this structure, a user may insert the second connector 350 into the first connector 310 of the charging device in a 180-degree rotated state.

According to an embodiment, an arrangement of pins formed on the first surface (e.g., an A surface) and the second surface (e.g., a B surface) of the contact substrate 305 is shown in Table 1 below.

**[Table 1]**

| Pin No. | Pin No. | Signal Name | Function | Note |
|---|---|---|---|---|
| A1 | B1 | GND | Power | Ground (e.g. Support for 60W minimum (combined with all VBUS pins)) |
| A2 | B2 | TX1+ or SSTXp1 | USB 3.1 or Alternate Mode | Super speed TX positive (e.g., 10Gb/s differential pair with TX1-) |
| A3 | B3 | TX1-or SSTXn1 | USB 3.1 or Alternate Mode | Super speed TX negative (e.g. 10Gb/s differential pair with TX1+) |
| A4 | B4 | VBUS | Power | USB cable charging power (e.g., Support for 60W minimum (combined with all VBUS pins)) |
| A5 | B5 | CC1, CC2 | CC or VCONN | Configuration Channel (CC) pins for identification |
| A6 | B6 | D+ | USB 2.0 | + line of the differential bi-directional USB signal |
| A7 | B7 | D- | USB 2.0 | - line of the differential bi-directional USB signal |
| A8 | B8 | SBU1, SBU2 | Alternate Mode | Side band Use: additional purpose pin (e.g., Audio signal, display signal, etc.) |
| A9 | B9 | VBUS | Power | USB cable charging power (e.g., Support for 60W minimum (combined with all VBUS pins) |
| A1 0 | B10 | RX2-or SSRXn2 | USB 3.1 or Alternate Mode | Super speed RX negative (e.g., 10Gb/s differential pair with RX2+) |
| A1 1 | B11 | RX2+ or SSRXp2 | USB 3.1 or Alternate Mode | Super speed RX positive (e.g., 10 Gb/s differential pair with RX2-) |
| A1 2 | B12 | GND | Power | Ground (e.g., Support for 60W minimum (combined with all VBUS pins)) |

According to an embodiment, the charging device may detect a physical connection of an external electronic device by coupling an external second connector 350 through the first connector 310. According to an embodiment, the charging device may detect the connection of the external electronic device and identify the external electronic device through at least one of a plurality of signal pins included in the first connector 310, for example, through an identification terminal (e.g., a configuration channel (CC) pin). For example, the charging device and/or the external electronic device connected via a USB Type-C connector may determine a power-related role or a data-related role of each of the electronic device and the external electronic device based on information detected through the CC pin. For example, in terms of data transmission, it may be determined whether to operate as a host device or a client device, and in terms of power supply, it may be determined whether to operate as a device that supplies power (e.g., a source device) or as a device that receives power (e.g., a sink device). For instance, as described above, when the charging device is referred to as a source device, the external electronic device may be referred to as a sink device.

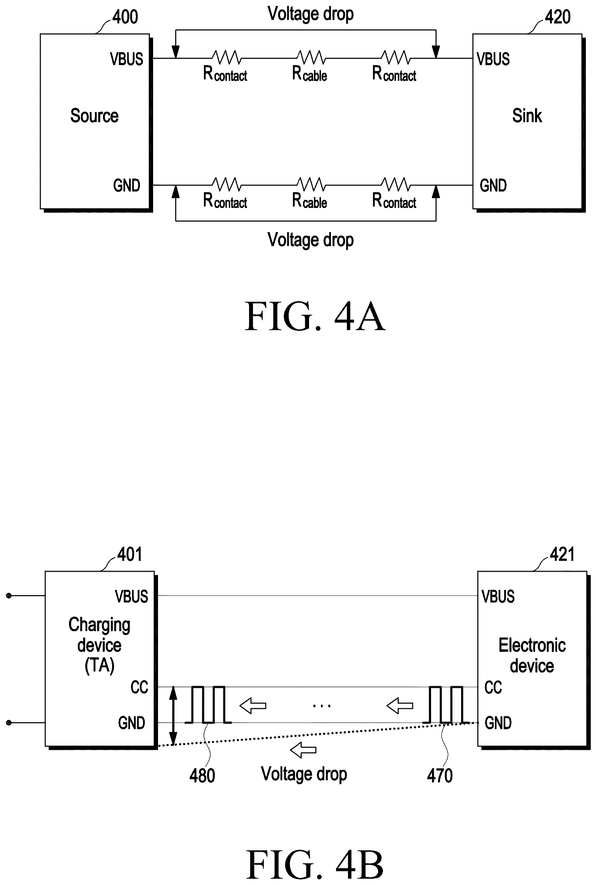

FIG. 4A is a diagram illustrating a voltage drop caused by a cable supporting USB Type-C and connecting a charging device and an electronic device according to an embodiment.

Referring to FIG. 4A, a charging device 400 (e.g., the charging device 200 of FIG. 2) according to an embodiment may be connected to an electronic device 420 through a cable supporting USB Type-C. For example, in terms of power supply, the charging device 400 may operate as a device that supplies power (e.g., a source device). In addition, the electronic device 420 may operate as a device configured to receive power (e.g., a sink device).

According to an embodiment, a cable may include a power line (VBUS) for transmitting power and a ground line (GND). For example, the power line (VBUS) may equivalently include a cable resistance (Rcable) and a contact resistance (Rcontact) caused by coupling of at least one connector. For example, the ground line (GND) may equivalently include a cable resistance (Rcable) and a contact resistance (Rcontact) caused by coupling of the connectors.

According to an embodiment, a signal transmitted through the cable may experience a voltage drop due to the cable resistance (Rcable) and the contact resistance (Rcontact) caused by coupling of at least one connector. For example, a power signal transmitted from the charging device 400 to the electronic device 420 through the power line (VBUS) may experience a voltage drop due to resistances (e.g., Rcable and Rcontact) included in the cable. For example, in a specification related to USB Type-C supporting USB Power Delivery (PD), the allowable range of voltage drop in the power line (VBUS) when the maximum current flows is specified to be within 500 mV. For example, a signal transmitted from the charging device 400 to the electronic device 420, or a signal transmitted from the electronic device 420 to the charging device 400 through a ground line (GND), may experience a voltage drop due to resistances (e.g., Rcable and Rcontact) included in the cable. For example, in a specification related to USB Type-C supporting USB Power Delivery (PD), the allowable range of voltage drop on the ground line (GND) when the maximum current flows is specified to be within 250 mV.

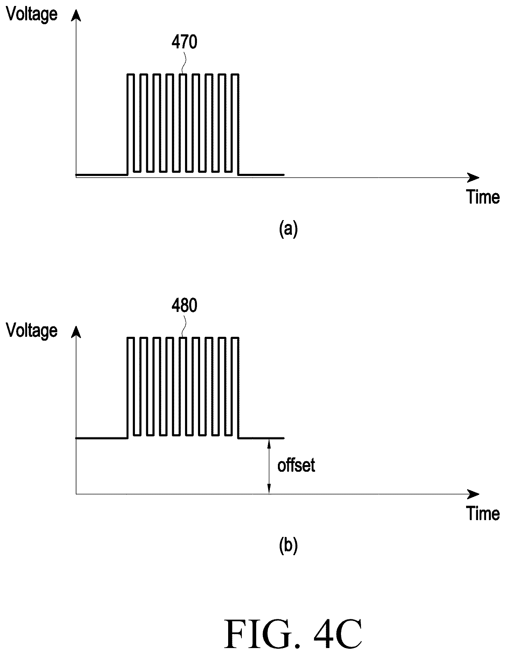

FIG. 4B is a diagram illustrating a voltage drop on a ground line included in a cable supporting USB Type-C according to a comparative embodiment. FIG. 4C is a diagram illustrating a change in a ground level of a communication signal received by a charging device, which is caused by a voltage drop on a ground line included in a cable supporting USB Type-C, according to a comparative embodiment.

Referring to FIG. 4B, according to a comparative embodiment, a charging device 401 and an electronic device 421 may transmit and receive communication signals for USB Power Delivery (PD) through a configuration channel (CC) line and a ground line (GND) of a cable. For example, the ground line (GND) may be identical to a ground line of a power line (VBUS).

According to an embodiment, when the electronic device 421 transmits a first communication signal 470 to the charging device 401 through the configuration channel (CC) line, the charging device 401 may receive a second communication signal 480 in a state in which a ground voltage level of the first communication signal 470 is reduced. For example, the first communication signal 470 may indicate a communication signal for USB Power Delivery (PD) transmitted from the electronic device 421 to the charging device 401, and the second communication signal 480 may indicate a communication signal for USB Power Delivery (PD) received by the charging device 401 from the electronic device 421.

Referring to (a) of FIG. 4C, according to a comparative embodiment, a ground voltage of a first communication signal 470 transmitted by the electronic device 420 may be 0 V or close to 0 V. Referring to (b) of FIG. 4C, according to a comparative embodiment, a ground voltage of a second communication signal 480 received by the charging device 401 may be floated by a voltage corresponding to an offset.

According to a comparative embodiment, when a voltage drop of the ground line (GND) exceeds a specified range, the charging device 401 may fail to accurately detect or analyze the second communication signal 480. For example, when a ground level of the second communication signal 480 is floated above a specified voltage level, the charging device 401 may fail to correctly determine whether the second communication signal 480 is in a low or high state. As a result, a communication error may occur between the charging device 400 and the electronic device 420. In addition, due to the occurrence of the communication error, the charging device 400 may fail to provide required power to the electronic device 420.

According to a comparative embodiment, when the charging device 401 transmits power to the electronic device 421 based on USB Power Delivery (PD), a cable connecting the charging device 400 and the electronic device 420 may be an uncertified or degraded cable. In this case, an excessive voltage drop may occur in a communication signal transmitted through the cable. For example, floating of a ground voltage of the communication signal may occur due to a difference between a ground voltage of the electronic device and a ground voltage of the charging device. As a result, a communication error may occur between the charging device 400 and the electronic device 420. In addition, due to the occurrence of the communication error, the electronic device 420 may fail to be charged properly by the charging device.

According to an embodiment, the charging device may subtract an offset of a ground voltage of a communication signal from the communication signal by connecting a compensation circuit including a detection circuit configured to detect a bottom voltage of the communication signal to a communication circuit (e.g., a decoder included in the communication circuit) for USB Power Delivery (PD). Accordingly, even when the charging device receives a communication signal through an uncertified or degraded cable, it may prevent or reduce communication errors by removing the offset of the ground voltage of the communication signal caused by a voltage drop on the ground line.

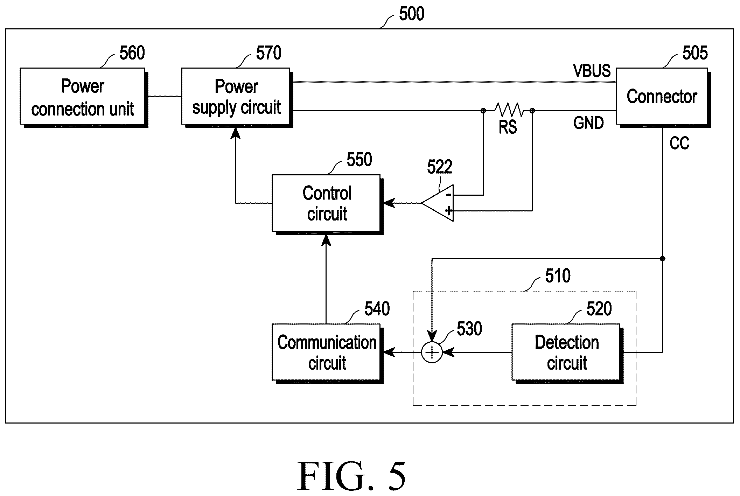

FIG. 5 is a block diagram illustrating a charging device that includes a compensation circuit configured to compensate a ground voltage of a communication signal received through a configuration channel (CC) line according to an embodiment.

Referring to FIG. 5, a charging device 500 (e.g., the charging device 200 of FIG. 2) according to an embodiment may include a connector 505, a compensation circuit 510, a communication circuit 540, a control circuit 550, a power connection unit 560, and a power supply circuit 570.

According to an embodiment, the charging device 500 may be implemented as a charger, an adapter, a laptop, a travel adapter (TA), or an auxiliary battery.

According to an embodiment, a connector 505 (e.g., the connector 203 of FIG. 2) may include an interface configured to be connected to an external electronic device through a cable. For example, the connector 505 may support Universal Serial Bus (USB) Type-C. According to an embodiment, the connector 505 may be a socket-type connector. The connector 505 may include a plurality of pins. For example, the plurality of pins may include a pin (VBUS) connected to a power line of the cable, a pin (GND) connected to a ground line of the cable, and a pin (CC) connected to a configuration channel (CC) line of the cable.

According to an embodiment, the compensation circuit 510 may include a detection circuit 520 and a signal synthesizer 530. For example, the compensation circuit 510 may remove an offset of a ground voltage from a communication signal for USB Power Delivery (PD) received from an electronic device through a configuration channel (CC) line of a cable. The compensation circuit 510 may output, to a communication circuit 540, a signal in which a ground voltage level of the communication signal is compensated by subtracting the offset of the ground voltage from the communication signal.

According to an embodiment, the detection circuit 520 may output a first signal indicating a bottom voltage of a communication signal for USB Power Delivery (PD) received from the electronic device through the configuration channel (CC) line of the cable. For example, the first signal may be a signal that tracks a bottom voltage included in the communication signal.

According to an embodiment, the signal synthesizer 530 may receive a communication signal received through the configuration channel (CC) line and the first signal. The signal synthesizer 530 may output, to a communication circuit 540, a second signal obtained by subtracting the first signal from the communication signal. For example, the second signal may indicate a signal from which an offset voltage of the communication signal caused by a voltage drop on a ground line of the cable is removed.

According to an embodiment, the communication circuit 540 may perform an operation related to communication for USB Power Delivery (PD). For example, the communication circuit 540 may receive the second signal in which an offset voltage of the communication signal caused by a voltage drop on the ground line of the cable is compensated. The communication circuit 540 may obtain information on USB PD communication with the electronic device based on the second signal. For example, the communication circuit 540 may obtain information on power corresponding to a target voltage and current requested by the electronic device based on the second signal and may output the obtained information to a control circuit 550.

According to an embodiment, the control circuit 550 may determine an output power of the charging device. For example, the control circuit 550 may determine the output power based on information (e.g., information on power having a target voltage and current requested by the electronic device) obtained from the communication circuit 540. For example, the control circuit 550 may control a power supply circuit 570 (e.g., an optocoupler (not shown) included in the power supply circuit 570) so that power corresponding to the target voltage and current is generated. For example, the control circuit 550 may adjust a voltage of the optocoupler to determine an output voltage and an output current of the power supply circuit 570.

According to an embodiment, the power supply circuit 570 may generate power to be externally output or supplied under control of the control circuit 550. For example, the power supply circuit 570 may receive power from an external power source (e.g., wall power) through a power connection unit 560 (e.g., a plug). The power supply circuit 570 may generate power corresponding to a voltage and current specified by the control circuit 550.

According to an embodiment, the control circuit 550 may identify a voltage applied across both terminals of a sensing resistor using an operational amplifier 522 and the current sensing resistor RS. The control circuit 550 may determine a current flowing through a ground line based on the detected voltage.

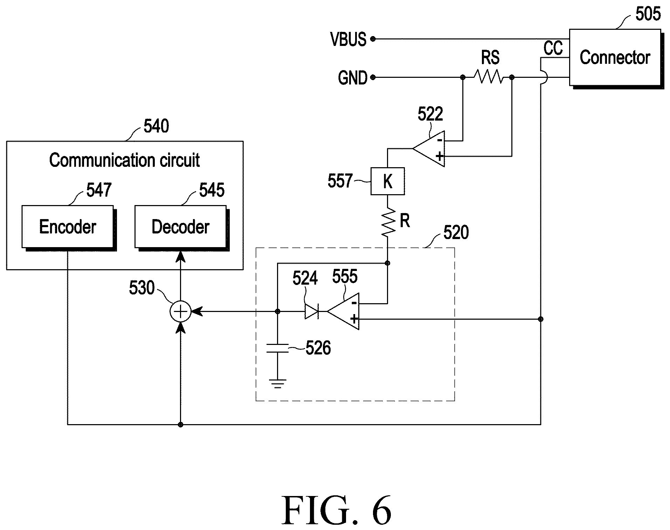

FIG. 6 is a circuit diagram illustrating a detection circuit configured to detect a bottom voltage of a communication signal received through a configuration channel (CC) line according to an embodiment.

Referring to FIG. 6, according to an embodiment, the detection circuit 520 may include an operational amplifier 555, a diode 524, and a capacitor 526. According to an embodiment, a communication signal received through the configuration channel (CC) line may be input to a first input terminal (e.g., a positive input terminal) of the operational amplifier 555, and a pull-up voltage may be input to a second input terminal (e.g., a negative input terminal) of the operational amplifier 555. For example, the pull-up voltage may be generated using a voltage (e.g., a voltage for sensing a current of a ground line) output from an operational amplifier 522. For example, a separate power supply voltage may be used as a pull-up voltage. For instance, the pull-up voltage may be generated based on a state of the ground line. For example, the pull-up voltage may be generated by multiplying a voltage for sensing a current of the ground line by a specified value (e.g., k). For example, a voltage for sensing a current of a ground line may be input to a voltage gain module 557, and a voltage obtained by multiplying the sensed voltage by a specified value may be generated. For example, the charging circuit 500 may generate a pull-up voltage by multiplying a voltage sensed for a current under a maximum current condition by a specified value (e.g., k). For example, the charging circuit 500 may control the pull-up voltage to have a voltage value greater than or equal to a voltage to be compensated. An initial value applied to a capacitor 526 included in the detection circuit 520 may be determined by the pull-up voltage. A resistor R may be disposed between the voltage gain module 557 and the operational amplifier 522. For example, the resistor R may be configured to limit a current input to the operational amplifier.

According to an embodiment, an output terminal of the operational amplifier 555 may be connected to a diode 524 oriented in a reverse direction. A voltage output from the diode 524 may be applied to a capacitor 526. For example, the voltage applied to the capacitor 526 may indicate a bottom voltage of a communication signal. A first signal indicating the voltage applied to the capacitor 526 may be provided to a signal synthesizer 530.

According to an embodiment, the signal synthesizer 530 may subtract the first signal from the communication signal. For example, the signal synthesizer 530 may compensate a ground level of the communication signal by subtracting the first signal from the communication signal. The signal synthesizer 530 may output, to a decoder 545 of a communication circuit 540, a second signal in which the ground level of the communication signal is compensated.

According to an embodiment, the communication circuit 540 may include a decoder 545 and an encoder 547. The encoder 547 may encode a communication signal to be transmitted from the charging circuit 500 to an electronic device. The decoder 545 may decode a communication signal received from the electronic device. According to an embodiment, the decoder 545 may decode a second signal in which a ground level of a communication signal received from the signal synthesizer is compensated. The communication circuit 540 may decode the second signal to obtain information on a target voltage and current requested by the electronic device.

Through the above-described circuit, the charging circuit 500 may accurately process or analyze a communication signal received from the electronic device even when a voltage drop occurs on a ground line of the cable.

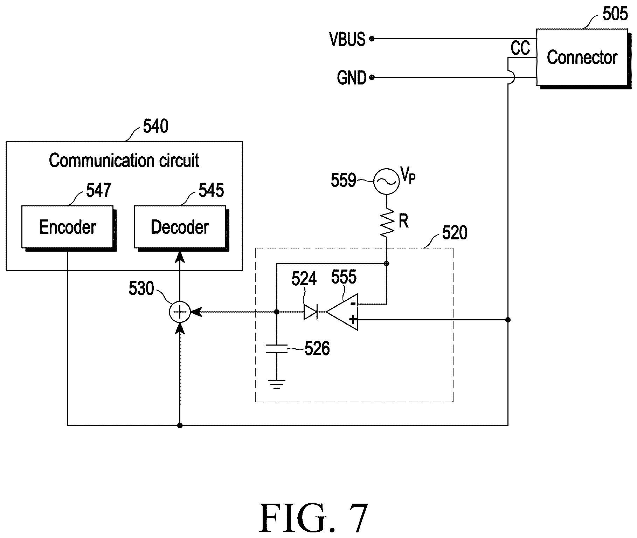

FIG. 7 is a circuit diagram illustrating a detection circuit configured to detect a bottom voltage of a communication signal received through a configuration channel (CC) line according to an embodiment.

Referring to FIG. 7, a detection circuit 520 according to an embodiment may receive a pull-up voltage Vp from a separate voltage source 559. For example, the detection circuit 520 of FIG. 7 may differ from the detection circuit 520 of FIG. 6 in a method of providing the pull-up voltage Vp.

According to an embodiment, the separate voltage source 559 may supply a specified voltage Vp to a capacitor 526 included in the detection circuit 520. The specified voltage Vp may be set as an initial voltage of the capacitor 526. For example, the specified voltage Vp may be a voltage value related to an allowable range of a voltage drop on a ground line.

As described above, the pull-up voltage applied to the capacitor 526 may be supplied by a control circuit 550 by multiplying a voltage for sensing a current by the specified value. Alternatively, the pull-up voltage applied to the capacitor 526 may be supplied through a separate voltage source.

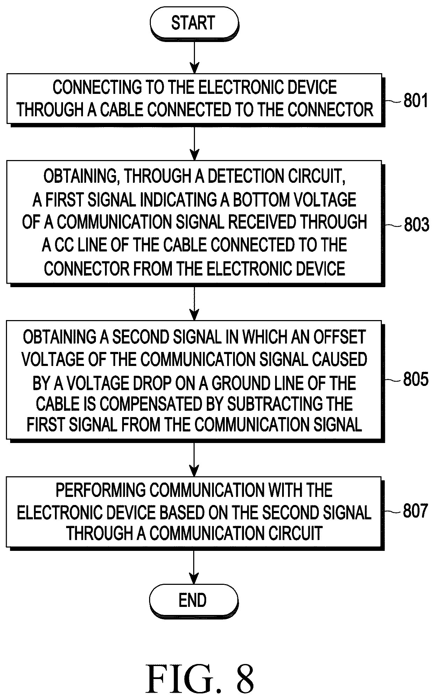

FIG. 8 is a flowchart illustrating an operation of a charging device that includes a compensation circuit configured to compensate a ground voltage of a communication signal received through a configuration channel (CC) line according to an embodiment.

Referring to FIG. 8, in operation 801 according to an embodiment, a charging device (e.g., the charging device 500 of FIG. 5) may be connected to an external electronic device through a cable connected to a connector (e.g., the connector 505 of FIG. 5). For example, the charging device 500 may be a source device that supplies power, and the electronic device may be a sink device that receives power. The charging device 500 may transmit power to the electronic device based on USB Power Delivery (PD). The charging device 500 may receive, from the electronic device, a communication signal related to USB Power Delivery (PD) through a configuration channel (CC) line of the cable connected to the connector 505. For example, the connector 505 may support USB Type-C.

According to an embodiment, in operation 803, the charging device 500 may obtain or detect, through a detection circuit (e.g., the detection circuit 520 of FIG. 5), a first signal indicating a bottom voltage of a communication signal related to USB Power Delivery (PD) received from the electronic device through a configuration channel (CC) line of a cable connected to the connector. The detection circuit 520 may output the first signal indicating the bottom voltage of the communication signal to a signal synthesizer (e.g., the signal synthesizer 530 of FIG. 5).

According to an embodiment, in operation 805, the charging device 500 may obtain, through a signal synthesizer 530, a second signal in which an offset voltage of a ground level of the communication signal is compensated (or removed) by subtracting the first signal from the communication signal.

According to an embodiment, in operation 807, the charging device 500 may communicate with the electronic device based on the second signal through a communication circuit for USB Power Delivery (PD) (e.g., the communication circuit 540 of FIG. 5). For example, the charging device 500 may decode the second signal through the communication circuit 540 and obtain information on a target voltage and current requested by the electronic device. The charging device 500 may control a power supply circuit (e.g., the power supply circuit 570 of FIG. 5) to generate the target voltage and current.

According to the above-described method, the charging device 500 may accurately process or analyze a communication signal received from the electronic device even when a voltage drop occurs on a ground line of the cable. Accordingly, the charging device 500 may smoothly perform USB PD communication with the electronic device.

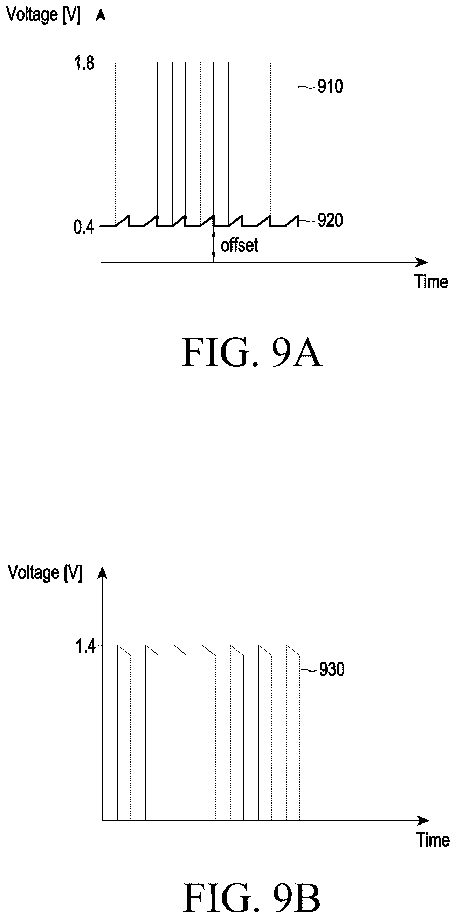

FIG. 9A is a graph illustrating a signal indicating a bottom voltage of a communication signal through a detection circuit according to an embodiment. FIG. 9B is a graph illustrating a signal in which a ground voltage of a communication signal is compensated through a compensation circuit according to an embodiment.

Referring to FIG. 9A, a charging device (e.g., the charging device 500 of FIG. 5) may receive a communication signal 910 for USB Power Delivery (PD) through a cable supporting USB Type-C. For example, a ground level of the communication signal 910 may be floated by an offset (e.g., 0.4 V). The charging device 500 may obtain and output, through a detection circuit (e.g., the detection circuit 520 of FIG. 5), a first signal 920 indicating a bottom voltage (e.g., 0.4 V) of the communication signal. For example, the detection circuit 520 may obtain and output, in real time, the first signal 920 indicating the bottom voltage of the communication signal.

Referring to FIG. 9B, the charging device 500 may obtain a second signal 930 by subtracting the first signal 920 from the communication signal 910. A bottom voltage of the second signal 930 may be 0 V or may be close to 0 V. That is, the second signal 930 may indicate a signal obtained by removing, from the communication signal 910, an offset voltage caused by a voltage drop on a ground line of the cable. The charging device 500 may perform USB PD communication with the electronic device based on the second signal.

According to the method described above, the charging device 500 may obtain, using the second signal 930, information on a target voltage and current requested by the electronic device even when a voltage drop occurs on a ground line of the cable. As a result, the charging device 500 may smoothly perform USB PD communication with the electronic device.

According to an embodiment, a charging device 500 supporting Universal Serial Bus (USB) Power Delivery (PD) may include a connector 505, a communication circuit 540, and a compensation circuit including a detection circuit 520 and a signal synthesizer 530. According to an embodiment, the compensation circuit may be configured to receive, through a configuration channel (CC) line of a cable connected to the connector, a communication signal related to charging an electronic device from the electronic device 421. According to an embodiment, the compensation circuit may be configured to obtain, through the detection circuit, a first signal indicating a bottom voltage of the communication signal. According to an embodiment, the compensation circuit may be configured to output, to the communication circuit, a second signal obtained by subtracting the first signal from the communication signal using the signal synthesizer, the second signal thereby having an offset voltage corresponding to a ground level of the communication signal removed therefrom. According to an embodiment, the communication circuit may be configured to perform USB PD communication with the electronic device based on the second signal.

According to an embodiment, the compensation circuit may be configured to output the second signal to a decoder included in the communication circuit.

According to an embodiment, the signal synthesizer may be configured to output, to the communication circuit, the second signal, in which the first signal is subtracted from the communication signal, based on the communication signal and the first signal.

According to an embodiment, the detection circuit may include an operational amplifier 555, a diode 524, and a capacitor 526. According to an embodiment, an output terminal of the operational amplifier may be connected to the diode oriented in a reverse direction.

According to an embodiment, a communication signal may be input to a first input terminal of the operational amplifier. According to an embodiment, a pull-up voltage may be input to a second input terminal of the operational amplifier.

According to an embodiment, the pull-up voltage may be generated by multiplying a voltage for sensing a current of a ground line of the charging device by a specified value.

According to an embodiment, the charging device may further include a voltage gain module 557 configured to multiply the voltage by the specified value.

According to an embodiment, the communication circuit may be configured to identify power corresponding to voltage or current requested by the electronic device based on the second signal.

According to an embodiment, the charging device may further include a control circuit 550. According to an embodiment, the control circuit may be configured to control a power supply circuit 570 included in the charging device to provide power corresponding to voltage or current to the electronic device.

According to an embodiment, the charging device may include a travel adapter (TA).

According to an embodiment, a method of operating a charging device 500 supporting Universal Serial Bus (USB) Power Delivery (PD) may include receiving, through a CC (configuration channel) line of a cable connected to a connector 505 of the charging device, a communication signal related to charging the electronic device 421 from the electronic device. According to an embodiment, the method of operating the charging device may include obtaining, using a detection circuit 520 included in the charging device, a first signal indicating a bottom voltage of the communication signal. According to an embodiment, the method of operating the charging device may include outputting, to a communication circuit 540 included in the charging device, a second signal obtained by subtracting the first signal from the communication signal using the signal synthesizer 530 included in the charging device, the second signal having an offset voltage corresponding to a ground level of the communication signal removed therefrom. According to an embodiment, the method of operating the charging device may include performing USB PD communication with the electronic device based on the second signal through the communication circuit.

According to an embodiment, the operation of outputting the second signal to the communication circuit may include outputting the second signal to a decoder included in the communication circuit.

According to an embodiment, the method of operating the charging device may further include subtracting the first signal from the communication signal through the signal synthesizer.

According to an embodiment, the detection circuit may include an operational amplifier 555, a diode 524, and a capacitor 526. According to an embodiment, an output terminal of the operational amplifier may be connected to the diode of a reverse direction.

According to an embodiment, the communication signal may be input to a first input terminal of the operational amplifier. According to an embodiment, a pull-up voltage may be input to a second input terminal of the operational amplifier.

According to an embodiment, the method of operating the charging device may further include generating the pull-up voltage by multiplying a voltage for sensing a current of a ground line of the charging device by a specified value.

According to an embodiment, the method of operating the charging device may further include multiplying the voltage by the specified value through a voltage gain module 557 included in the charging device.

According to an embodiment, the method of operating the charging device may further include determining power of voltage or current requested by the electronic device based on the second signal through the communication circuit.

According to an embodiment, the method of operating the charging device may further include controlling a power supply circuit 570 included in the charging device to provide power corresponding to voltage or current to the electronic device.

According to an embodiment, the charging device may include a travel adapter (TA).

The electronic device according to various embodiments of the disclosure may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "portion," or "circuitry". A module may be a single integral component, or a minimum unit or portion thereof, adapted to perform one or more functions. For example, according to an embodiment, the module may be implemented in a form of an application-specific integrated circuit (ASIC).

Various embodiments of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smartphones) directly. If distributed online, at least portion of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A charging device (500) configured to support Universal Serial Bus (USB) Power Delivery (PD) comprises:
a connector (505);
a communication circuit (540); and
a compensation circuit (510) including a detection circuit (520) and a signal synthesizer (530),
wherein the compensation circuit is configured to:
receive, using a configuration channel (CC) line of a cable connected to the connector, a communication signal from an electronic device (421), wherein the communication signal is related to charging the electronic device;
obtain, through the detection circuit, a first signal indicating a bottom voltage of the communication signal;
output, to the communication circuit, a second signal in which an offset voltage corresponding to a ground level of the communication signal is removed by subtracting the first signal from the communication signal, using the signal synthesizer;
wherein the communication circuit is configured to perform USB PD communication with the electronic device based on the second signal.

2. The charging device of claim 1, wherein the compensation circuit is configured to output the second signal to a decoder included in the communication circuit.

3. The charging device of claim 1 or 2,
wherein the signal synthesizer is configured to output, to the communication circuit, the second signal obtained by subtracting the first signal from the communication signal, based on the communication signal and the first signal.

4. The charging device of any one of claims 1 to 3, wherein the detection circuit includes an operational amplifier (555), a diode (524), and a capacitor (526),
wherein an output terminal of the operational amplifier is connected to the diode of a reverse direction.

5. The charging device of any one of claims 1 to 4, wherein the communication signal is input to a first input terminal of the operational amplifier, and a pull-up voltage is input to a second input terminal of the operational amplifier.

6. The charging device of any one of claims 1 to 5, wherein the pull-up voltage is generated by multiplying a voltage for sensing a current of a ground line of the charging device by a specified value.

7. The charging device of any one of claims 1 to 6, further comprising:
a voltage gain module (557) configured to multiply the voltage by the specified value.

8. The charging device of any one of claims 1 to 7, wherein the communication circuit is configured to identify power of the voltage or current requested by the electronic device based on the second signal.

9. The charging device of any one of claims 1 to 8, further comprising:
a control circuit (550) configured to control a power supply circuit (570) included in the charging device to provide the power corresponding to the voltage or current to the electronic device.

10. The charging device of any one of claims 1 to 9, wherein the charging device includes a travel adapter (TA).

11. A method of operating a charging device (500) configured to support Universal Serial Bus (USB) Power Delivery (PD), the method comprising:
receiving, through a configuration channel (CC) line of a cable connected to a connector (505) of the charging device, a communication signal related to charging of an electronic device, from the electronic device (421);
obtaining, using a detection circuit (520) included in the charging device, a first signal indicating a bottom voltage of the communication signal;
outputting, to a communication circuit (540) included in the charging device, a second signal obtained by subtracting the first signal from the communication signal using a signal synthesizer (530) included in the charging device, the second signal having an offset voltage corresponding to a ground level of the communication signal removed therefrom; and
performing USB PD communication with the electronic device based on the second signal through the communication circuit.

12. The method of claim 11, wherein the operation of outputting the second signal to the communication circuit includes outputting the second signal to a decoder included in the communication circuit.

13. The method of claim 11 or 12, further comprising subtracting the first signal from the communication signal using the signal synthesizer (530).

14. The method of any one of claims 11 to 13,
wherein the detection circuit includes an operational amplifier (555), a diode (524), and a capacitor (526), and
wherein an output terminal of the operational amplifier is connected to the diode of a reverse direction.

15. The method of any one of claims 11 to 14,
wherein the communication signal is input to a first input terminal of the operational amplifier, and
wherein a pull-up voltage is input to a second input terminal of the operational amplifier.
